# EUROPÄISCHE PATENTSCHRIFT

(11) **EP 1 882 269 B1**
(45) Veröffentlichungstag und Bekanntmachung des Hinweises auf die Patenterteilung: **18.02.2009**
(21) Anmeldenummer: 06723895.6
(22) Anmeldetag: 31.03.2006
(51) Int. Cl.: H01L 23/552

(54) **Vorrichtung zur Dämpfung von Reflexionen elektromagnetischer Wellen, Verfahren zur Herstellung und ihre Verwendung**
Apparatus for attenuating reflections of electromagnetic waves. method for its manufacture and its use
Dispositif d'atténuation des réflexions d'ondes electromagnétiques, son procédé de production et son utilisation

(30) Priorität: 14.05.2005 DE 102005022473
(43) Veröffentlichungstag der Anmeldung: 30.01.2008
(73) Patentinhaber: Forschungszentrum Karlsruhe GmbH, 76133 Karlsruhe (DE)
(72) Erfinder: SEEMANN, Klaus, 76448 Durmersheim (DE); LEISTE, Harald, 76356 Weingarten (DE); BEKKER, Viacheslav, 76227 Karlsruhe (DE); ZILS, Stefan, 76275 Ettlingen (DE)
(86) Internationale Anmeldenummer: PCT/EP2006/002934
(87) Internationale Veröffentlichungsnummer: WO 2006/122608

(56) Entgegenhaltungen:
- EP-A- 1 508 917
- US-A1- 2002 067 313
- US-B1- 6 483 481

## Beschreibung

Die Erfindung betrifft eine Vorrichtung zur Dämpfung von Reflexionen einer auf die Vorrichtung auftreffenden elektromagnetischen Welle, ein Verfahren zu ihrer Herstellung und ihre Verwendung.

Elektromagnetische Wellen werden überwiegend durch einfache Metallisierungen aus Kupfer oder Aluminium abgeschirmt, wobei die Welle nahezu vollständig reflektiert und deren Energie nicht dissipiert wird. Nichtmagnetische Metalle reflektieren lediglich eine elektromagnetische Welle mit geringem Energieverlust; es findet kaum Dissipation statt.

Magnetische Schichten wie z.B. Folien aus FeNi bewirken bei der ferro- oder ferrimagnetischen Resonanz eine teilweise Absorption und Umwandlung der elektromagnetischen Energie in andere Energieformen, insbesondere in Wärme, und damit eine Dämpfung der Welle. Hierbei ist der Frequenzbereich der Energiedissipation jedoch eingeschränkt und deckt im Wesentlichen den unteren MHz- und den kHz-Bereich ab. Eine Verbesserung der Abschirmung einer elektromagnetischen Welle lässt sich durch die magnetische Permeabilität erzielen; der sog. *Skin-Effekt* verhindert ein tieferes Eindringen der Welle in ein Gehäuse. Nachteilig hieran ist, dass der Bereich der maximalen Energieabsorption jedoch nicht einstellbar ist.

Aus H. Okumura, D.J. Twisselmann, R.D. McMichael, M.Q. Huang, Y.N. Hsu, D.E. Laughlin und M.E. McHenry, Magnetic and structural characterization and ferromagnetic resonance study of thin film HITPERM soft magnetit materials for data storage applications, J. Appl. Phys. 93, 2003, S. 6528-30, ist eine Vorrichtung aus ein oder mehreren Lagen dünner Schichten aus amorphen magnetischen Materialien bekannt, wobei jeweils eine Schicht eine Resonanzfrequenz aufweist.

O. Acher, C. Boscher, B. Brulé, G. Perrin, N. Vukadinovic, G. Suran O. Acher, C. Boscher, B. Brulé, G. Perrin, N. Vukadinovic, G. Suran und H. Joisten offenbaren in Microwave permeability of ferromagnetic thin films with stripe domain structure, J. Appl. Phys. 81, 1997, S. 4057-59, einen ebenen amorphen ferromagnetischen Film, der Streifendomänen besitzt.

In G. Perrin, J.C. Peuzin, und O. Acher, Control of the resonance frequency of soft ferromagnetic amorphous thin films by strip patterning, J. Appl. Phys. 81, 1997, S. 5166-68, und in M. Vroubel, Y. Zhuang, B. Rejaei und J. Burghartz, Patterned FeNi thin film for RF and microwave components, J. Magnetism and Magn. Materials 258-259, 2003, S. 167-169, werden mittels Photolithographie dünne, parallele Streifen aus amorphen ferromagnetischen Filmen auf ein Substrat aufgebracht. Hierdurch lässt sich die Frequenz der ferromagnetischen Resonanz eines Filmes zu höheren Werten verschieben.

Die US 20020067313 A1 und die US 6,483,481 B1 offenbaren jeweils Vorrichtungen zur Dämpfung von Reflexionen einer auf die Vorrichtung auftreffenden elektromagnetischen Welle, die auf ein Substrat aufgebracht sind und eine metallische Schicht umfassen, in die eine Struktur so eingebracht ist, dass unterhalb der Struktur eine durchgängige Schicht besteht. Nachteilig an diesen Vorrichtungen ist, dass die aufgebrachten Strukturen Resonanzfrequenzen zur einfallenden Welle nur aufgrund ihrer Geometrie besitzen. Um mehr als eine Resonanzfrequenz zu erzeugen, ist es daher jeweils erforderlich, dass für jede Resonanzfrequenz genauso viele Arten von unterschiedlichen Geometrien in der Struktur vorhanden sind.

Ausgehend davon ist es die Aufgabe der Erfindung, eine ferro- oder ferrimagnetische Schicht, ein Verfahren zu ihrer Herstellung und ihre Verwendung anzugeben, die die vorher genannten Nachteile und Einschränkungen nicht aufweisen. Insbesondere soll eine Vorrichtung, die die Reflexion und Transmission elektromagnetischer Wellen durch ferro- oder ferrimagnetische Dünnschichten über einen weiten Frequenzbereich oder für diskrete Frequenzen dämpft, ein Verfahren zu ihrer Herstellung und ihre Verwendung angegeben werden.

Gelöst wird die Aufgabe durch die Merkmale des Patentanspruchs 1, durch ein Verfahren mit den Merkmalen des Patentanspruchs 10 und durch die Verwendung des Patentanspruchs 12. Die Unteransprüche beschreiben jeweils vorteilhafte Ausgestaltungen der Erfindung.

Eine erfindungsgemäße Vorrichtung dient der Dämpfung von Reflexionen einer auf die Vorrichtung auftreffenden elektromagnetischen Welle, die bevorzugt eine Frequenz zwischen 1 MHz und 10 GHz, besonders bevorzugt zwischen 250 MHz und 5 GHz aufweist.

Eine erfindungsgemäße Vorrichtung ist auf einem Substrat aufgebracht. Hierzu dient jedes Material, solange hierauf ein ferro- oder ferrimagnetisches Material haftet. Dazu gehören z. B. ein Silizium-Wafer oder das Gehäuse eines elektronischen Bauteils.

Eine erfindungsgemäße Vorrichtung besteht aus einer durchgängigen Schicht aus einem ferro- oder ferrimagnetischen Material, die eine Dicke vorzugsweise zwischen 50 nm und 2 µm, besonders bevorzugt zwischen 200 nm und 1 µm besitzt. Durch Wahl des ferro- bzw. ferrimagnetischen Materials und, falls erforderlich, des Induzierens einer uniaxialen Anisotropie in der Schichtebene wird eine erste ferromagnetische Resonanzfrequenz erzeugt, die in Resonanz eine Aufnahme der elektromagnetischen Energie im Material und deren Umwandlung in andere Energieformen wie z.B. in Wärme diskret oder über ein Frequenzspektrum bewirkt.

Weiterhin ist diese Schicht erfindungsgemäß derart mit einer Struktur versehen, dass unterhalb dieser Struktur eine durchgehende Schicht aus dem ferro- oder ferrimagnetischen Material besteht. Durch die Strukturierung wird mindestens eine weitere ferromagnetische Resonanzfrequenz bereitgestellt, die in Resonanz ebenfalls eine Aufnahme der elektromagnetischen Energie im Material und deren Umwandlung in andere Energieformen bewirkt. Damit weist die strukturierte Schicht mindestens zwei voneinander verschiedene Resonanzfrequenzen auf.

Mehreren Resonanzfrequenzen werden durch ein auf ein bestimmtes Abschirmproblem zugeschnittenes Schichtdesign erhalten. Hierdurch können mehrere elektromagnetische Wellen mit jeweils verschiedener Frequenz reflexions- oder transmissionsgedämpft werden.

In einer bevorzugten Ausgestaltung ist die Struktur in der Schicht periodisch angeordnet und weist vorzugsweise eine Periode zwischen 10 µm und 250 µm, besonders bevorzugt zwischen 20 µm und 50 µm auf.

In einer besonderen Ausgestaltung setzt sich die Struktur aus Objekten mit annährend gleichen Abmessungen zusammen, die sich jeweils nebeneinander befinden. Hierzu wird die Schicht aus dem ferro- oder ferrimagnetischen Material ganz oder teilweise zu mikromagnetischen Objekten wie z.B. Quadrate, Rechtecke, Vielecke, Ellipsen oder Kreise strukturiert. Hierbei ist wichtig, dass die gewählten Domänenstrukturen dem gewünschten Frequenzspektrum entsprechen.

In einer weiteren Ausgestaltung befinden sich derartige Objekte nebeneinander, wobei die jeweils übernächsten Nachbarn annährend gleiche Abmessungen aufweisen. Diese Art der Ausgestaltung lässt sich dahingehend verallgemeinern, dass sich die Struktur aus sich nebeneinander befindlichen Objekten zusammensetzt, wobei die jeweils n-ten Nachbarn annährend gleiche Abmessungen aufweisen und n eine natürliche Zahl bevorzugt zwischen 2 und 20 ist.

Eine erfindungsgemäße ferro- oder ferrimagnetische Schicht wird mittels eines Dünnschichtverfahren als Ein- oder Mehrlagenschicht mit oder ohne uniaxiale Anisotropie bzw. mit oder ohne isolierende oder leitende Zwischenschichten auf ein Substrat wie z. B. auf einen Wafer oder vorzugsweise gleich auf ein Gehäuse eines elektronischen Bauteils aufgebracht.

Anschließend wird die Schicht durch Mikrostrukturtechniken in einzelne Bereiche strukturiert. Die auf diese Weise erzeugten Objekte weisen beliebige Formen und Abmessungen wie z.B. quadratische, rechteckige, runde, elliptische oder ringförmige Geometrien auf. Um ein bestimmtes Frequenzspektrum zu erhalten, werden unterschiedliche Schichten und Geometrien mit verschiedenen lateralen Abmessungen realisiert und kombiniert. Dabei bestimmen sowohl die Form der Domänenstruktur als auch die chemische Zusammensetzung der Schicht das jeweilige Frequenz- und Dämpfungsverhalten.

Der Vorteil der erfindungsgemäßen Vorrichtung besteht darin, dass bei Emission elektromagnetischer Wellen durch Hochfrequenz-Bauteile die Störung benachbarter Bauteile durch eine geringere Mehrfachreflexion verringert wird. Die Erfindung erlaubt somit eine Einstellung der Frequenz der maximalen Dämpfung, womit ein oder mehrere Frequenzbereiche unterdrückt bzw. gedämpft werden. Zudem weist eine erfindungsgemäße Vorrichtung eine geringe Ausdehnung und ein geringes Gewicht auf. Damit findet die Erfindung Verwendung zur Abschirmung von elektronischen Bauteilen in der Elektronik-, Telekommunikations-, Automobil- und Luftfahrt-Industrie über die die mindestens zwei Resonanzfrequenzen umgebenden Frequenzbereiche.

Die Erfindung wird im Folgenden an Hand eines Ausführungsbeispiels mit Hilfe der Abbildungen näher erläutert. Es zeigen:
- **Fig. 1**: Schematische Darstellung einer beispielhaften erfindungsgemäßen Vorrichtung
- **Fig. 2**: Permeabilität als Funktion der Frequenz der unstrukturierten Schicht (Vergleichsversuch)
- **Fig. 3**: Permeabilität als Funktion der Frequenz der erfindungsgemäß strukturierten Schicht

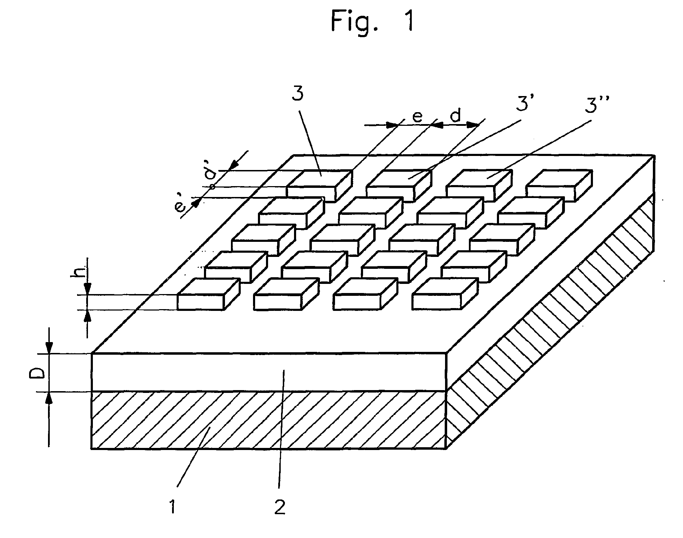

Als Substrat diente, wie in **Fig. 1** schematisch dargestellt, ein kommerziell erhältlicher Silizium-Wafer **1**, der an seiner Oberfläche mit einer 1 µm dicken Schicht aus SiO₂ versehen war. Hierauf wurde mittels Magnetron-Sputtern eine ca. 300 nm dicke Schicht **2** aus dem ferromagnetischen Material FeCoTaN aufgebracht.

Anschließend wurden in diese Schicht mittels Ätzen nebeneinander angeordnete Quadrate **3,3',3"**, ... mit einer Seitenlänge **d** = 40 µm und einem Abstand e = 5 µm als periodische Struktur mit einer Periode **p = d + e** = 45 µm in die beiden zueinander senkrechten Richtungen eingebracht. Der Ätzprozess wurde gestoppt, als die Quadrate **3, 3', 3",** ... eine Höhe **h** von ca.
100 nm über der verbleibenden Schicht **2** aufweisen, deren Dicke **D** noch ca. 200 nm betrug.

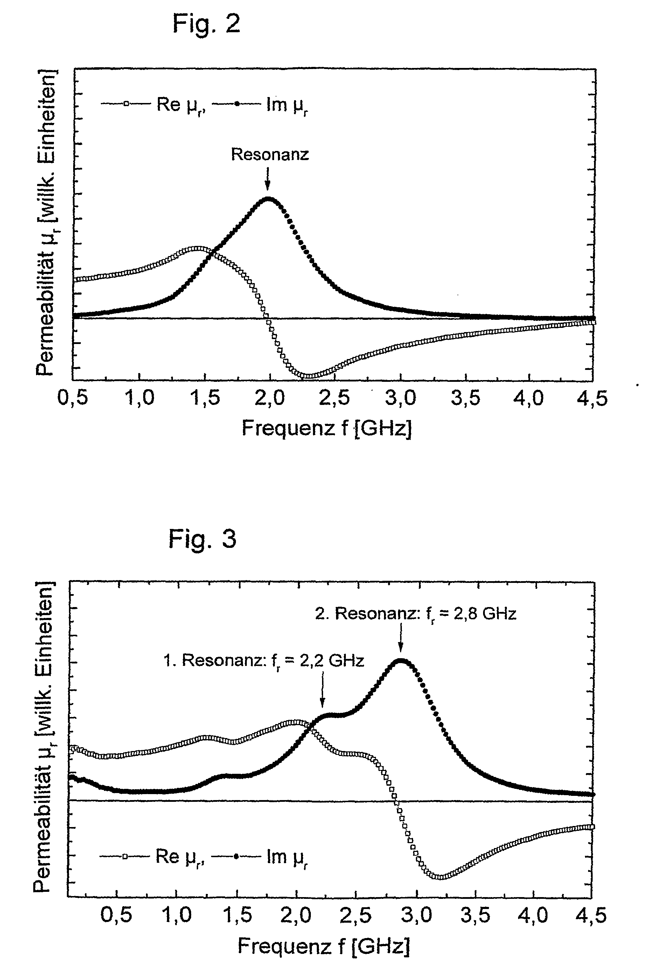

Anhand des Realteils *Re* und Imaginärteils *Im* der Permeabilität µᵣ als Funktion der Frequenz f wurden die Resonanzfrequenzen des ferromagnetischen Materials ohne bzw. mit Strukturierung ermittelt. Die in den **Fig. 2** und **3** dargestellten Funktionen wurden mit einem Stripline-Permeameter aufgenommen.

In **Fig. 2** sind als Vergleichsversuch der Realteil *Re* und der Imaginärteil *Im* der Permeabilität µᵣ der unstrukturierten Schicht als Funktion der Frequenz f dargestellt. Im Imaginärteil *Im* ist deutlich das Maximum der ferromagnetischen Resonanz der Schicht **2** bei einem Wert von ca. 2 GHz zu erkennen.

**Fig. 3** zeigt den Realteil *Re* und den Imaginärteil *Im* der Permeabilität µᵣ der oben hergestellten erfindungsgemäß strukturierten Schicht als Funktion der Frequenz f. Im Imaginärteil *Im* sind sehr ausgeprägt die beiden Maxima der strukturierten Schicht bei Werten von ca. 2,2 GHz und 2,8 GHz zu erkennen. Während ein Maximum von der ferromagnetischen Resonanz der Schicht **2** hervorgerufen wird, wird das zweite Maximum von der in die Schicht eingebrachten periodischen Struktur bewirkt. Durch diese Anordnung der Maxima ergibt sich eine Dämpfung von Reflexionen einer auf die Vorrichtung auftreffenden elektromagnetischen Welle mit einer Frequenz über einen Bereich zwischen ca. 1,5 GHz und ca. 3,5 GHz.

## Patentansprüche

1. Vorrichtung zur Dämpfung von Reflexionen einer auf die Vorrichtung auftreffenden elektromagnetischen Welle, aufgebracht auf ein Substrat (1) und umfassend eine Schicht (2), in die eine Struktur (3, 3', 3", ...) so eingebracht ist, dass unterhalb der Struktur eine durchgängige Schicht (2) besteht, **dadurch gekennzeichnet, dass** die Schicht aus einem ferro- oder ferrimagnetischen Material besteht, wodurch die auftreffende elektromagnetischen Welle in der Schicht (2) eine erste ferro- oder ferrimagnetische Resonanzfrequenz und in der in die Schicht eingebrachten Struktur (3, 3' , 3" , ...) mindestens eine weitere ferro- oder ferrimagnetische Resonanzfrequenz erzeugt.

2. Vorrichtung nach Anspruch 1, **dadurch gekennzeichnet, dass** die Struktur (3, 3', 3" , ...) periodisch ist und eine Periode zwischen 10 µm und 250 µm aufweist.

3. Vorrichtung nach Anspruch 2, **dadurch gekennzeichnet, dass** die Struktur (3, 3', 3", ...) eine Periode zwischen 20 µm und 50 µm aufweist.

4. Vorrichtung nach Anspruch 2 oder 3, **dadurch gekennzeichnet, dass** die Struktur (3, 3', 3", ...) aus sich nebeneinander befindlichen Objekten gleicher Abmessungen zusammengesetzt ist.

5. Vorrichtung nach Anspruch 2 oder 3, **dadurch gekennzeichnet, dass** die Struktur (3, 3', 3'', ...) aus sich nebeneinander befindlichen Objekten zusammengesetzt ist, wobei die jeweils übernächsten Nachbarn gleiche Abmessungen aufweisen.

6. Vorrichtung nach einem der Ansprüche 1 bis 5, **dadurch gekennzeichnet, dass** die Dicke der Schicht (2) zwischen 50 nm und 2 µm beträgt.

7. Vorrichtung nach Anspruch 6, **dadurch gekennzeichnet, dass** die Dicke der Schicht (2) zwischen 200 nm und 1 µm beträgt.

8. Vorrichtung nach einem der Ansprüche 1 bis 7, **dadurch gekennzeichnet, dass** die elektromagnetische Welle eine Frequenz zwischen 1 MHz und 10 GHz aufweist.

9. Vorrichtung nach Anspruch 8, **dadurch gekennzeichnet, dass** die elektromagnetische Welle eine Frequenz zwischen 250 MHz und 5 GHz aufweist.

10. Verfahren zur Herstellung einer Vorrichtung nach einem der Ansprüche 1 bis 9, **dadurch gekennzeichnet, dass** eine Schicht (2) aus einem ferro- oder ferrimagnetischen Material auf ein Substrat (1) aufgebracht wird und anschließend Teile der Schicht (2) derart entfernt werden, dass sich die Struktur (3, 3', 3", ...) bildet und unterhalb der Struktur (3, 3', 3" , ...) eine durchgängige Schicht (2) aus dem ferro- oder ferrimagnetischen Material verbleibt.

11. Verfahren nach Anspruch 10, **dadurch gekennzeichnet, dass** die Schicht (2) auf ein Gehäuse eines elektronischen Bauteils als Substrat (1) aufgebracht wird.

12. Verwendung einer Vorrichtung nach einem der Ansprüche 1 bis 9 zur Abschirmung von elektronischen Bauteilen.

## Claims

1. Device for attenuating reflections of an electromagnetic wave that impinges on the device, the said device being mounted on a substrate (1) and comprising a layer (2), into which a structure (3, 3', 3", ...) is introduced such that there is a continuous layer (2) beneath the structure, **characterised in that** the layer is produced from a ferromagnetic or ferrimagnetic material, the impinging electromagnetic resonance frequency thereby generating a first ferromagnetic or ferrimagnetic resonance frequency in the layer (2) and at least one additional ferromagnetic or ferrimagnetic resonance frequency in the structure (3, 3', 3", ...) that has been introduced into the layer.

2. Device according to claim 1, **characterised in that** the structure (3, 3', 3", ...) is periodic and includes a period between 10 µm and 250 µm.

3. Device according to claim 2, **characterised in that** the structure (3, 3', 3", ...) is periodic and includes a period between 20 µm and 50 µm.

4. Device according to claim 2, **characterised in that** the structure (3, 3', 3", ...) is composed of same-sized objects that are located adjacent each other.

5. Device according to claim 2 or 3, **characterised in that** the structure (3, 3', 3", ...) is composed of objects that are located adjacent each other, every other neighbouring object having the same dimensions.

6. Device according to one of claims 1 to 5, **characterised in that** the thickness of the layer (2) is between 50 nm and 2 µm.

7. Device according to claim 6, **characterised in that** the thickness of the layer (2) is between 200 nm and 1 µm.

8. Device according to one of claims 1 to 7, **characterised in that** the electromagnetic wave has a frequency between 1 MHz and 10 GHz.

9. Device according to claim 8, **characterised in that** the electromagnetic wave has a frequency between 250 MHz and 5 GHz.

10. Method for producing a device according to one of claims 1 to 9, **characterised in that** a layer (2) made of a ferromagnetic or ferrimagnetic material is applied to a substrate (1) and parts of the layer (2) are then removed in such a manner that the structure (3, 3', 3", ...) is formed and a continuous layer (2) produced from ferromagnetic or ferrimagnetic material remains beneath the structure (3, 3', 3", ...).

11. Method according to claim 10, **characterised in that** the layer (2) is applied to a housing of an electronic component in the form of a substrate (1).

12. Use of a device according to one of claims 1 to 9 for shielding electronic components.

## Revendications

1. Dispositif pour amortir les réflexions d'une onde électromagnétique arrivant sur le dispositif, ce dispositif étant appliqué sur un substrat (1) et comprenant une couche (2) dans laquelle on a réalisé une structure (3, 3', 3",...) de façon à obtenir une couche continue (2) sous la structure,
**caractérisé en ce que**
la couche est en matière ferro- ou ferrimagnétique,
l'onde électromagnétique incidente arrivant dans la couche (2) génère une première fréquence de résonnance ferro- ou ferrimagnétique et dans la structure (3, 3', 3",...), réalisée dans la couche, on génère au moins une autre fréquence de résonnance ferro- ou ferrimagnétique.

2. Dispositif selon la revendication 1,
**caractérisé en ce que**
la structure (3, 3', 3",...) est périodique et présente une période comprise entre 10 µm et 250 µm.

3. Dispositif selon la revendication 2,
**caractérisé en ce que**
la structure (3, 3', 3",...) à une période comprise entre 20 µm et 50 µm.

4. Dispositif selon la revendication 2 ou 3,
**caractérisé en ce que**
la structure (3, 3', 3",...) se compose d'objets juxtaposés de mêmes dimensions.

5. Dispositif selon la revendication 2 ou 3,
**caractérisé en ce que**
la structure (3, 3', 3",...) se compose d'objets juxtaposés et chaque fois des seconds voisins suivants ont les mêmes dimensions.

6. Dispositif selon les revendications 1 à 5,
**caractérisé en ce que**
l'épaisseur de la couche (2) est comprise entre 50 nm et 2 µm.

7. Dispositif selon la revendication 6,
**caractérisé en ce que**
l'épaisseur de la couche (2) est comprise entre 200 nm et 1 µm.

8. Dispositif selon les revendication 1 à 7,
**caractérisé en ce que**
l'onde électromagnétique a une fréquence comprise entre 1 MHz et 10 GHz.

9. Dispositif selon la revendication 8,
**caractérisé en ce que**
l'onde électromagnétique a une fréquence comprise entre 250 MHz et 5 GHz.

10. Procédé de fabrication d'un dispositif selon les revendications 1 à 9,
**caractérisé par**
une couche (2) en matière ferro- ou ferrimagnétique appliquée sur un substrat (1), puis on enlève des parties de la couche (2) de façon à former la structure (3, 3', 3",...) et à laisser en dessous de la structure (3, 3', 3",...), une couche continue (2) en matière ferro- ou ferrimagnétique.

11. Procédé selon la revendication 10,
**caractérisé en ce que**
la couche (2) est appliquée sur un boîtier d'un composant électronique constituant le substrat (1).

12. Application d'un dispositif selon les revendications 1 à 9 pour réaliser le blindage de composants électroniques.
